# EUROPEAN PATENT APPLICATION

(11) **EP 2 952 918 A1**
(43) Date of publication of application: **09.12.2015**
(21) Application number: 15170094.5
(22) Date of filing: 01.06.2015
(51) Int. Cl.: G01R 31/04, G01R 31/309

(54) **OPTICAL NON-DESTRUCTIVE INSPECTION METHOD AND OPTICAL NON-DESTRUCTIVE INSPECTION APPARATUS**

(30) Priority: 05.06.2014 JP 2014116848
(71) Applicant: JTEKT CORPORATION, Osaka-shi Osaka 542-8502 (JP)
(72) Inventor: Matsumoto, Naoki, Osaka-shi, Osaka, 542-8502 (JP); Matsumoto, Jun, Osaka-shi, Osaka, 542-8502 (JP); Yoshida, Kouya, Osaka-shi, Osaka, 542-8502 (JP); Seo, Ryotaro, Osaka-shi, Osaka, 542-8502 (JP)
(74) Representative: Winter, Brandl, Fürniss, Hübner, Röss, Kaiser, Polte - Partnerschaft mbB

(57) **Abstract**

An optical non-destructive inspection method includes: heating including setting a measurement spot (SP) on a surface of a workpiece and irradiating the measurement spot with heating laser light using a heating laser light source (21), heat ray detectors (31, 32), and a controller (50); acquiring a temperature rise property that is a temperature rise state of the measurement spot according to a heating time by detecting a heat ray radiated from the measurement spot to determine a temperature at the measurement spot; and determining whether or not a pressure contact state at pressure contact portions (91B, 92B), which include a contact area and a contact pressure, is appropriate based on the temperature rise property.

## Description

### BACKGROUND OF THE INVENTION

### 1. Field of the Invention

The present invention relates to an optical non-destructive inspection method and an optical non-destructive inspection apparatus in which a pressure contact state at pressure contact portions of two workpieces coupled together by pressure contact without being soldered is determined.

### 2. Description of Related Art

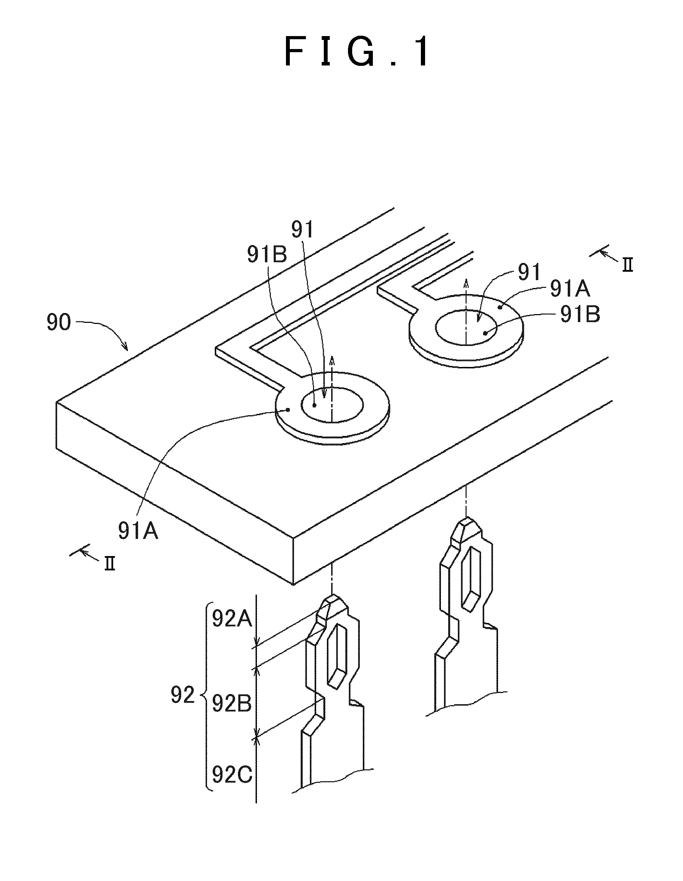

In recent years, control units of various sizes have been developed which are intended to be used for automobiles, home electrical appliances, and the like. Various electronic circuit boards are used in the control unit, and a variety of contacts and the like are assembled to the electronic circuit board. For example, as depicted in FIG. 1, through-holes 91 each with an inner wall 91B of copper foil, tin plating, or the like are formed in the circuit board 90. Press fit pins 92 that are contacts may be press-fitted into the through-holes 91. In this case, the inner wall 91B (pressure contact portion) of the through-hole 91 is a conductive member such as the copper foil or the tin plating, and an elastic deformation portion 92B (pressure contact portion) of the press fit pin 92 is also a conductive member. The outer diameter of the elastic deformation portion 92B of the press fit pin 92 is set slightly larger than the inner diameter of the inner wall 91B. When inserted in the through-hole 91, the elastic deformation portion 92B of the press fit pin 92 is deformed to reduce the outer diameter thereof and comes into pressure contact with the inner wall 91B of the through-hole 91 due to an elastic restoration force. The contact area and contact pressure of each of the pressure contact portions in the pressure contact state affect the conductivity of the pressure contact portion. For example, if the elastic deformation portion 92B of the press fit pin 92 is abnormally deformed, leading to a significantly small area of contact with the inner wall 91B of the through-hole 91 or a significantly low contact pressure on the inner wall 91B of the through-hole 91, then the conductivity lowers and a desired conductivity may fail to be ensured or electric continuity may fail to be established. Furthermore, when the press fit pin 92 is inserted into the through-hole 91, the inner wall 91B of the through-hole 91 may be shaved to preclude the desired conductivity from being ensured. Thus, various methods and apparatuses have been disclosed in which the inserted state or pressure contact state of the press fit pin 92 inserted into the through-hole 91 is inspected.

For example, Japanese Patent No. 5175681 (JP 5175681 B) describes an inserted-state inspection apparatus for a press fit terminal in which an inspection hole that is a through-hole is formed at a portion of a press fit pin, which sticks out from a circuit board when the press fit pin is inserted into an insertion hole in the circuit board so that the position of the inspection hole is detected before and after the press fit pin is inserted into the insertion hole in the circuit board, to allow determination of whether or not the inserted state is appropriate. At the time of the detection, a light emitting section radiates light to the press fit pin to take a transmission image or a reflection image. The inserted state of the press fit pin is inspected based on the positions of the inspection hole in the images taken before and after the insertion.

Furthermore, Japanese Patent Application Publication No. 2010-86868 (JP 2010-86868 A) describes a joined-state inspection apparatus for a press fit pin in which a reflected wave receiver is connected to a propagating wave receiver. The reflected wave receiver includes a vibrator of an ultrasonic oscillator that is in abutting contact with a tip of the press fit pin inserted into an insertion hole in a circuit board and receives a reflected wave from the tip of the press fit pin, The propagating wave receiver receives a propagating wave from a conductor (a land of a through-hole into which the press fit pin is inserted) that is on the opposite side from a tip of the press fit pin with respect to the insertion hole and contiguous with the insertion hole with which the press fit pin is in pressure contact. In the inspection, whether or not the joined state is appropriate is determined by performing comparison with at least one of a reference reflected wave waveform and a reference propagating wave waveform obtained from the press fit pin in an appropriate joined state.

The invention described in JP 5175681 B allows the inserted state of the press fit pin inserted into the insertion hole in the circuit board to be determined via the image but fails to allow inspection of the pressure contact state between the press fit pin and the insertion hole. Thus, inspection of an electrically continuous state that is the original purpose may fail to be achieved. Even when the press fit pin is inserted into the correct position, a desired electrically continuous state may fail to be established depending on a deformed state of the pressure contact portion of the press fit pin, a shaved state of the inner wall of the insertion hole in the circuit board, or the like.

The invention described in JP 2010-86868 A allows the pressure contact state between the press fit pin and the insertion hole to be inspected. However, the inspection is not easy because, for inspection, the vibrator of the ultrasonic oscillator, a pin receiving a propagating wave, and the like need to be fixed to the tip of the press fit pin or to the vicinity of the press fit pin at desired positions in a desired manner.

### SUMMARY OF THE INVENTION

An object of the present invention is to provide an optical non-destructive inspection method and an optical non-destructive inspection apparatus that allow a pressure contact state at a pressure contact portion to be more easily, quickly, and appropriately inspected.

An optical non-destructive inspection method according to an aspect of the present invention determines a pressure contact state at pressure contact portions of two workpieces coupled together by pressure contact without being soldered and in which the pressure contact portion of a first workpiece and the pressure contact portion of a second workpiece are formed of conductive members.

The optical non-destructive inspection method uses: a heating laser light source that sets a measurement spot on a surface of the first workpiece near the pressure contact portion, the surface being a surface of the conductive member including the pressure contact portion, the heating laser light source emitting heating laser light with a predetermined laser wavelength; at least one heat ray detector that enables a heat ray to be detected; and a controller that controls the heating laser light source and that retrieves a detection signal from the heat ray detector. The optical non-destructive inspection method includes: heating the measurement spot by controlling the heating laser light source via the controller to irradiate the measurement spot with the heating laser light adjusted to have an amount of heat at which the workpieces are heated without being destroyed; acquiring a temperature rise property that is a temperature rise state of the measurement spot according to a heating time by, while performing the heating through the heating step, detecting, via the controller, a heat ray radiated from the measurement spot using the heat ray detector to determine a temperature at the measurement spot; and determining, via the controller, whether or not the pressure contact state at the pressure contact portions of the two workpieces, which includes a contact area and a contact pressure of each pressure contact portion is appropriate based on the temperature rise property of the measurement spot that is a heating point affected by an amount of heat transferred.

According to the above-described aspect, when, for example, the workpieces are a press fit pin and a through-hole and the press fit pin is inserted through the through-hole so that the press fit pin (conductive member) is coupled to an inner wall of the through-hole (conductive member) by pressure contact without being soldered, the measurement spot is set at a tip of the press fit pin and the heating laser light is radiated to the measurement spot to determine the temperature rise property. Thus, whether or not the contact area and contact pressure of the pressure contact portion are normal can be appropriately determined. Furthermore, the temperature rise property can be obtained for the two workpieces in a noncontact manner, allowing easier determination. Additionally, the use of heating laser light with an appropriate output allows a desired temperature rise property to be obtained in a very short time. That is, whether or not the pressure contact portion is in a desired electrically continuous state (pressure contact state) can be more easily, quickly, and appropriately inspected.

In the optical non-destructive inspection method in the above-described aspect, at least one of the pressure contact portions of the two workpieces may be plated with an alloy or a metal having a lower melting point than each of the conductive members of the pressure contact portions of the two workpieces. In the heating, the controller may control the heating laser light source to irradiate the measurement spot with the heating laser light with an output adjusted to an amount of heat at which the workpieces are heated without being destroyed and which corresponds to a melting point lower than a melting point of the plating. The method may further include soldering the two workpieces at the pressure contact portions when the workpieces are determined to be acceptable in the determination, the soldering including increasing, via the controller, the output of the heating laser light source so that the heating laser light source provides new heating laser light with an output adjusted to an amount of heat at which the workpieces are heated without being destroyed and which corresponds to a melting point equal to or higher than the melting point of the plating, and then irradiating the measurement spot with the new heating laser light for a predetermined time to melt the plating.

In the above-described aspect, after the two workpieces coupled together by pressure contact without being soldered are determined to be in the desired pressure contact state, the pressure contact portions can be appropriately and easily soldered in the soldering. Furthermore, plating shaved portions or fine slivers of tin or the like may be melted to establish a more reliable pressure contact state (electrically continuous state).

In the optical non-destructive inspection method in the above-described aspect, at least one of the pressure contact portions of the two workpieces may be plated with an alloy or a metal having a lower melting point than each of the conductive members of the pressure contact portions of the two workpieces. In the heating, the controller may control the heating laser light source to irradiate the measurement spot with the heating laser light with an output adjusted to an amount of heat at which the workpieces are heated without being destroyed and which corresponds to a melting point equal to or higher than a melting point of the plating.

In the above-described aspect, the heating and the soldering can be executed at the same time, allowing inspection of the pressure contact state to be performed in a shorter time.

In the optical non-destructive inspection method in the above-described aspect, in the determination, when a duration from a start point of radiation of the heating laser light to the measurement spot until a heat equilibrium state is established where a temperature rise with respect to an elapsed time is equal to or lower than a predetermined rise does not fall between a preset first reference threshold and a preset second reference threshold, the controller may determine the workpiece to be a defective workpiece with the contact area falling out of a range of areas of desired sizes or with the contact pressure falling out of a range of desired pressures.

In the above-described aspect, since the determination is made based on the duration until the temperature rise property exhibits the heat equilibrium state, the contact area or the contact pressure can be appropriately determined to fall out of the range of the desired area or the range of the desired pressure

An optical non-destructive inspection apparatus according to another aspect of the present invention is an optical non-destructive inspection apparatus that executes the optical non-destructive inspection method in the above-described aspect, the apparatus including: the heating laser light source; a light concentrating collimator that concentrates parallel light entering the light concentrating collimator through a first side thereof along an optical axis, at the measurement spot set as a focal position so that the light exits the light concentrating collimator through a second side thereof, the light concentrating collimator converting the light entering the light concentrating collimator through the second side thereof after radiation and reflection from the measurement spot, into measurement light that is parallel light along the optical axis so that the measurement light exits the light concentrating collimator through the first side thereof; a heating laser light guide that converts the heating laser light into parallel light and guides the parallel light to the first side of the light concentrating collimator; the at least one heat ray detector; a heat ray light guide that guides a heat ray contained in the measurement light and corresponding to heat radiated from the measurement spot to the heat ray detector, and the controller.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1 is a perspective view illustrating an example of the appearance of two workpieces (a press fit pin and a through-hole) that are measurement targets and that have not been coupled together;
FIG. 2 is a sectional view of the workpieces taken along line II-II in FIG. 1 and in which the press fit pin has been inserted through the through-hole;
FIG. 3 is an enlarged view of a part III in FIG. 2 illustrating the position of a measurement spot, radiation of a heat ray (infrared ray), the manner of transfer of heat from the measurement spot to a pressure contact portion, and the like;
FIG. 4 is a diagram illustrating an example of a configuration of an optical non-destructive inspection apparatus;
FIG. 5 is a flowchart illustrating an example of a process procedure for an optical non-destructive inspection method;
FIG. 6 is a diagram illustrating a relationship between an infrared wavelength, infrared energy, and temperature;
FIG. 7 is a diagram illustrating a relationship between the temperature and the ratio of energy of infrared rays with two different wavelengths (two-wavelength ratio);
FIG. 8 is a diagram illustrating an example of a measured temperature rise property;
FIG. 9 is a diagram illustrating a normalized temperature rise property resulting from normalization of the temperature rise property by compression in a temperature (vertical axis) direction;
FIG. 10 is a diagram illustrating a normalized temperature rise property resulting from normalization of the temperature rise property by extension in the temperature (vertical axis) direction;
FIG. 11 is a diagram illustrating an example where a normalized ideal temperature rise property, a normalized lower limit temperature rise property, and a normalized upper limit temperature rise property are superimposed on one another; and
FIG. 12 is a diagram illustrating an example where information on a determination result for the pressure contact state of a measurement target is displayed on a display.

### DETAILED DESCRIPTION OF EMBODIMENTS

Modes for carrying out the present invention will be described below with reference to the drawings.

An example of a measurement target will be described using FIG. 1. FIG. 1 illustrates an example of the appearance of a through-hole 91 formed in a circuit board 90 and a press fit pin 92; the through-hole 91 and the press fit pin 92 are measurement targets. In the description of the present embodiment, the through-hole 91 and the press fit pin 92 correspond to two workpieces that are the measurement targets. The through-hole 91 has, with respect to the through-hole formed in the circuit board 90, an inner wall 91B that is an inner wall portion of the through-hole 91 and a land 91A provided at an edge of the through-hole. The land 91A is provided on each of front and back surfaces of the circuit board 90 and is connected to the inner wall 91B. The land 91A is connected to, for example, another land for attachment of an electronic component on the circuit board 90, through wiring printed on the circuit board 90. The inner wall 91B and the land 91A are formed of conductive members (for example, copper foil or solder plating). In the present embodiment, the inner wall 91B corresponds to a pressure contact portion of the through-hole 91.

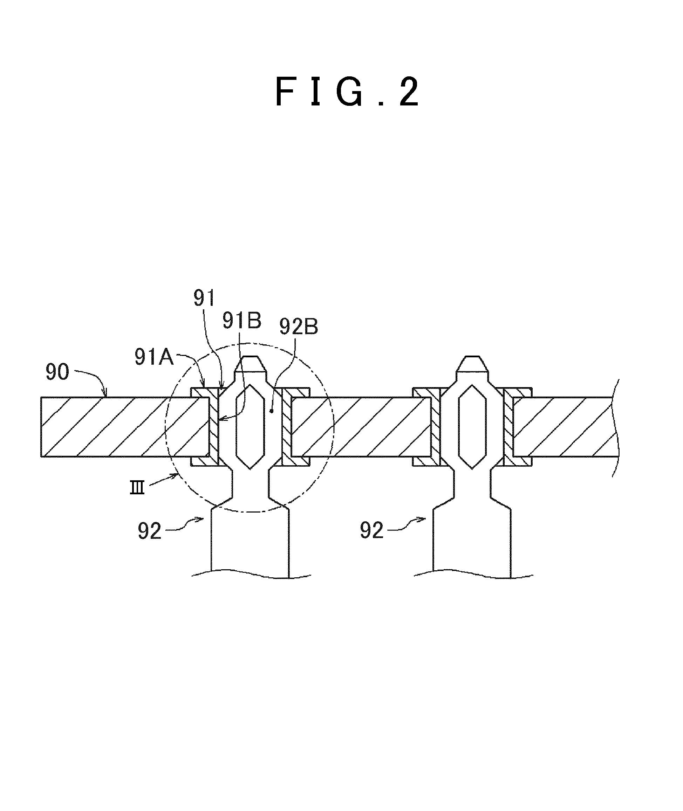

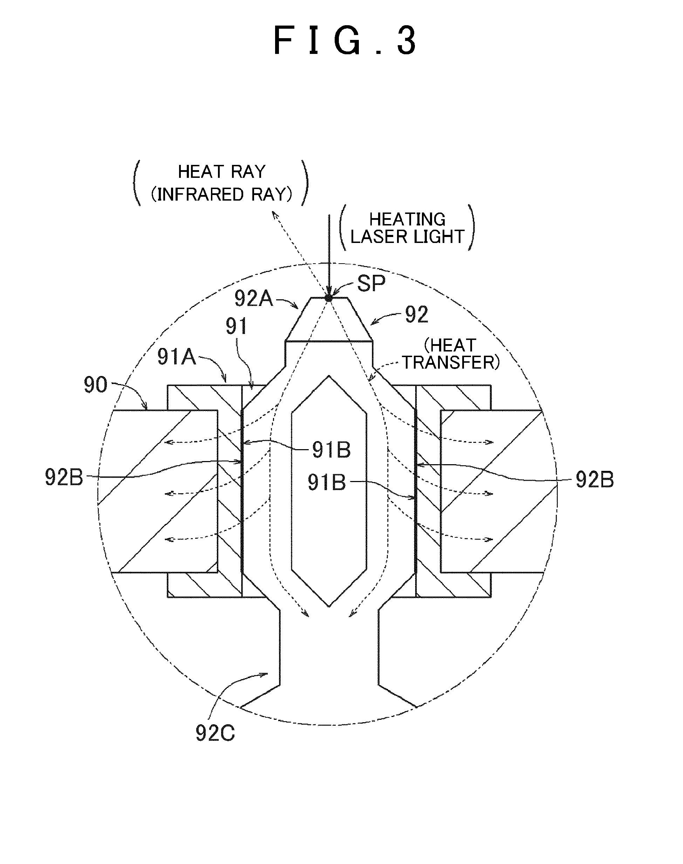

The press fit pin 92 is formed of a conductive member and has a tip portion 92A, an elastic deformation portion 92B, a base portion 92C, and the like. The width of the elastic deformation portion 92B is set slightly larger than the inner diameter of the inner wall 91B of the through-hole 91. When the press fit pin 92 is inserted through the through-hole 91 from the tip portion 92A to the elastic deformation portion 92B, the elastic deformation portion 92B is deformed to come into pressure contact with the inner wall 91B due to a restoration force of elastic deformation. Thus, the press fit pin 92 is coupled to the through-hole 91 in pressure contact therewith without being soldered (see FIG. 2 and FIG. 3). In the present embodiment, the elastic deformation portion 92B corresponds to a pressure contact portion of the press fit pin 92.

When the pressure contact portion of the press fit pin 92 (elastic deformation portion 92B) is not in appropriate pressure contact with the pressure contact portion of the through-hole 91 (inner wall 91B), a desired electrically continuous state may fail to be ensured, leading to inappropriate electric continuity. For example, when the press fit pin 92 is abnormally deformed in the inner wall 91B and the pressure contact portions have excessively small contact areas, the pressure contact portions have excessively low contact pressures, or the inner wall 91B is significantly shaved by the elastic deformation portion 92B, inappropriate electric continuity such as excessively high electric resistance may occur.

A heat propagation state may be used to determine whether or not the pressure contact state between the inner wall 91B of the through-hole 91 and the elastic deformation portion 92B of the press fit pin 92 is the desired state (desired contact area and desired contact pressure). For example, as depicted in FIG. 3, a measurement spot SP is formed at a tip of the press fit pin 92, which is a surface of one of the workpieces near the pressure contact portion and that is also a surface of the conductive member including the pressure contact portion. The measurement spot SP is irradiated with heating laser light and heated in a noncontact manner. Then, the temperature of the measurement spot SP gradually rises to propagate heat from the measurement spot SP via the press fit pin 92 and the inner wall 91B. A heat ray (infrared ray) according to the elevated temperature is radiated through the press fit pin 92 including the measurement spot SP and the through-hole 91. When the radiated heat ray (infrared ray) is measured in a noncontact manner to determine the temperature at the measurement spot SP, the propagation state of heat (illustrated by a dashed line in FIG. 3) radiated through the pressure contact portion can be indirectly measured to determine the contact area and contact pressure of the pressure contact portion.

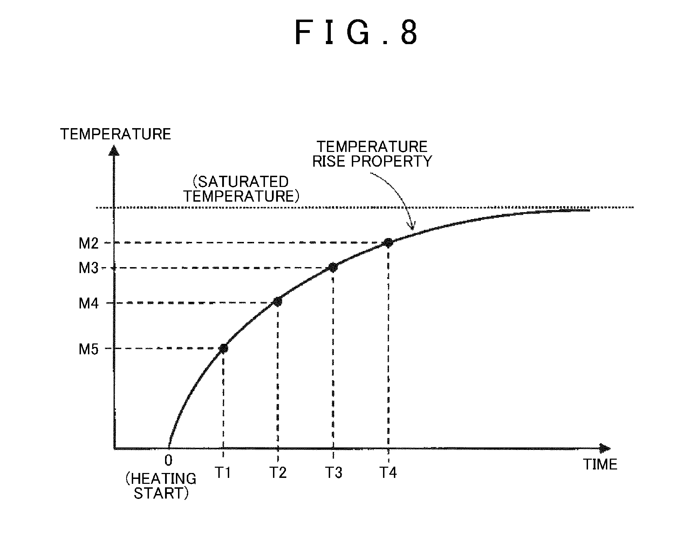

The temperature of the measurement spot SP gradually rises, but when a saturated temperature is reached at which the amount of heating is equal to the amount of radiation, the rise in temperature stops and a substantially constant temperature is maintained even on continued heating. In this regard, when the pressure contact portion has a relatively large contact area or a relatively high contact pressure, a large amount of heat is transferred. Thus, the rise in temperature according to a heating time is relatively slow, and the saturated temperature is relatively low. When the pressure contact portion has a relatively small contact area or a relatively low contact pressure, a small amount of heat is transferred. Thus, the rise in temperature according to the heating time is relatively rapid, and the saturated temperature is relatively high. Therefore, heating laser light is radiated to the measurement spot SP, and such a temperature rise property as illustrated in FIG. 8 is measured. Then, based on the temperature rise property, whether or not the contact area and contact pressure of the pressure contact portion fall within allowable ranges is determined so that whether or not the pressure contact state is appropriate is determined. An example of a configuration of an optical non-destructive inspection apparatus that enables determination of whether or not the pressure contact state is appropriate as described above, and an optical non-destructive inspection method will be described in detail.

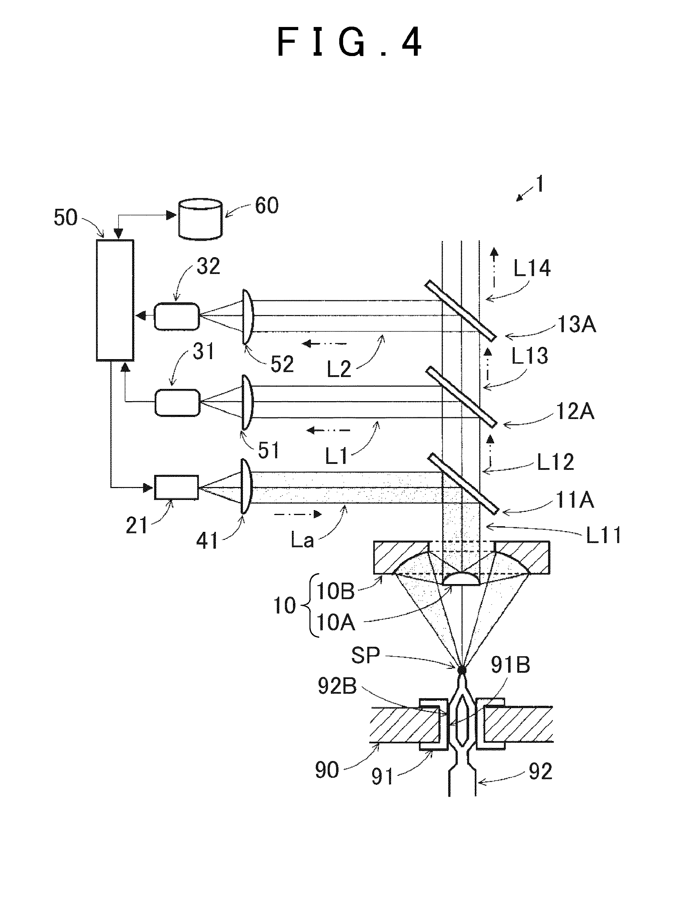

FIG. 4 depicts an example of a configuration of an optical non-destructive inspection apparatus 1. The optical non-destructive inspection apparatus 1 includes a light concentrating collimator 10, a heating laser light source 21, a heating laser collimator 41, a heating laser selective reflector 11A, a first infrared detector 31 (corresponding to a heat ray detector), a first infrared selective reflector 12A, a first infrared light concentrator 51, a second infrared detector 32 (corresponding to a heat ray detector), a second infrared selective reflector 13A, a second infrared light concentrator 52, a controller 50, and a storage 60.

The light concentrating collimator 10 concentrates parallel light entering the light concentrating collimator 10 through a first side thereof (the upper side in the example in FIG. 4) along an optical axis thereof, at the measurement spot SP set on the measurement target as a focal position so that the light exits the light concentrating collimator 10 through a second side (the lower side in the example in FIG. 4). Furthermore, the light concentrating collimator 10 converts light entering the light concentrating collimator 10 through the second side after radiation and refection from the measurement spot SP (that is the focal position), into first measurement light L11 that is parallel light along the optical axis of the light concentrating collimator 10 so that the light exits the light concentrating collimator 10 through the first side thereof. The light concentrating collimator 10 may be formed of a light concentrating lens that transmits and refracts light. However, light with a plurality of different wavelengths is handled, and thus a light concentrating lens with possible chromatic aberration is not very preferable. Thus, the light concentrating collimator 10 is configured using aspheric reflection mirrors 10A and 10B so that occurrence of chromatic aberration is eliminated and light of wider wavelength can be handled.

The heating laser light source 21 emits heating laser light with a heating laser light wavelength (λa) adjusted to an output that enables the measurement target to be heated without destruction, based on a control signal from the controller 50. For example, the heating laser light source 21 is a semiconductor laser light source that emits blue laser light of λ = approximately 450 [nm]. The heating laser collimator 41 is arranged near the heating laser light source 21 (near a laser emission position and on the optical axis of the heating laser light) to convert the heating laser light emitted by the heating laser light source 21 into heating laser light La of parallel light. For example, the heating laser collimator 41 may be a collimate lens because the heating laser collimator 41 may be able to exclusively convert the heating laser light wavelength (λa) into parallel light. The heating laser collimator 41 may be omitted given that the heating laser light source 21 can emit the heating laser light of parallel light.

The heating laser selective reflector 11A is arranged on the optical axis of the light concentrating collimator 10 to reflect the heating laser light La with the heating laser light wavelength (λa) that is parallel light into which light emitted by the heating laser light source 21 has been converted, toward the first side of the light concentrating collimator 10, while transmitting second measurement light L12 that is parallel light exiting the light concentrating collimator 10 through the first side thereof after radiation and reflection from the measurement spot SP and having a wavelength different from the heating laser light wavelength (λa). For example, the heating laser selective reflector 11A is a dichroic mirror that reflects light with the heating laser light wavelength (λa) while transmitting light with a wavelength other than the heating laser light wavelength (λa). Measurement light that is the parallel light exiting the light concentrating collimator 10 through the first side thereof after radiation and reflection from the measurement spot SP is referred to as the first measurement light L11. Remaining measurement light resulting from removal of the light with the heating laser light wavelength from the first measurement light L11 is referred to as the second measurement light L12. The heating laser collimator 41 and the heating laser selective reflector 11A provide a heating laser light guide that converts the heating laser light emitted by the heating laser light source 21 into parallel light and guides the parallel light to the first side of the light concentrating collimator 10.

The first infrared detector 31 can detect the energy of an infrared ray (heat ray) radiated from the measurement spot SP. For example, the first infrared detector 31 is an infrared sensor. A detection signal from the first infrared detector 31 is loaded into the controller 50. The first infrared selective reflector 12A is arranged on a path of the first measurement light L11 that is parallel light exiting the light concentrating collimator 10 through the first side thereof and transmitted through the heating laser selective reflector 11A (parallel light with a wavelength different from the heating laser light wavelength). The first infrared selective reflector 12A reflects, toward the first infrared detector 31, parallel light L1 of infrared rays with a first infrared wavelength (λ1) contained in the second measurement light L12 that is parallel light exiting the light concentrating collimator 10 through the first side thereof and transmitted through the heating laser selective reflector 11A, while transmitting third measurement light L13 that is parallel light with a wavelength different from the first infrared wavelength (λ1).

Therefore, the first infrared detector 31 detects only the energy of an infrared ray with the first infrared wavelength (λ1). For example, the first infrared selective reflector 12A is a dichroic mirror that reflects light with the first infrared wavelength (λ1), while transmitting light with a wavelength other than the first infrared wavelength (λ1). The first infrared light concentrator 51 is arranged near the first infrared detector 31 (near a detection position) to concentrate, at the first infrared detector 31, infrared rays of the parallel light L1 with the first infrared wavelength (λ1) reflected by the first infrared selective reflector 12A. For example, the first infrared light concentrator 51 may be a light concentrating lens because the first infrared light concentrator 51 may be able to exclusively concentrate the light with the first infrared wavelength (λ1). The heating laser selective reflector 11A, the first infrared selective reflector 12A, and the first infrared light concentrator 51 provide a first radiating infrared light guide (corresponding to a heat ray light guide). The first radiating infrared light guide guides, to the first infrared detector 31, infrared rays with the first infrared wavelength (λ1) contained in the second measurement light L12 that is parallel light radiated from the measurement spot SP and exiting the light concentrating collimator 10 through the first side thereof.

The second infrared detector 32 can detect the energy of an infrared ray (heat ray) radiated from the measurement spot SP. For example, the second infrared detector 32 is an infrared sensor. A detection signal from the second infrared detector 32 is loaded into the controller 50. The second infrared selective reflector 13A is arranged on a path of the third measurement light L13 that is parallel light exiting the light concentrating collimator 10 through the first side thereof and transmitted through the heating laser selective reflector 11A and the first infrared selective reflector 12A (parallel light with a wavelength different from the heating laser light wavelength and the first infrared wavelength). The second infrared selective reflector 13A reflects, toward the second infrared detector 32, parallel light L2 of infrared rays with a second infrared wavelength (λ2) contained in the third measurement light L13 that is parallel light exiting the light concentrating collimator 10 through the first side thereof and transmitted through the heating laser selective reflector 11A and the first infrared selective reflector 12A, while transmitting fourth measurement light L14 that is parallel light with a wavelength different from the second infrared wavelength (λ2). The fourth measurement light L14 that is transmitted parallel light is unnecessary and thus allowed to be absorbed by a light absorber or the like.

Therefore, the second infrared detector 32 detects only the energy of an infrared ray with the second infrared wavelength (λ2). For example, the second infrared selective reflector 13A is a dichroic mirror that reflects light with the second infrared wavelength (λ2), while transmitting light with a wavelength other than the second infrared wavelength (λ2). The second infrared light concentrator 52 is arranged near the second infrared detector 32 (near a detection position) to concentrate infrared rays of the parallel light L2 with the second infrared wavelength (λ2) reflected by the second infrared selective reflector 13A, at the second infrared detector 32. For example, the second infrared light concentrator 52 may be a light concentrating lens because the second infrared light concentrator 52 may be able to exclusively concentrate the light with the second infrared wavelength (λ2). The heating laser selective reflector 11A, the first infrared selective reflector 12A, the second infrared selective reflector 13A, and the second infrared light concentrator 52 provide a second radiating infrared light guide (corresponding to a heat ray light guide). The second radiating infrared light guide guides, to the second infrared detector 32, infrared rays with the second infrared wavelength (λ2) contained in the second measurement light L12 that is parallel light radiated from the measurement spot SP and exiting the light concentrating collimator 10 through the first side thereof.

The controller 50 is a personal computer or the like and controls the heating laser light source 21 to retrieve the detection signal from the first infrared detector 31 and the detection signal from the second infrared detector 32 while heating the measurement spot SP using the heating laser light. The controller 50 thus measures the temperature at the measurement spot SP based on the ratio between the detection signal from the first infrared detector 31 and the detection signal from the second infrared detector 32. A method for measuring the temperature will be described below. The controller 50 then measures a temperature rise property that is the temperature rise state of the measurement spot according to the heating time to determine the pressure contact state of the measurement target based on the measured temperature rise property. Operations of the controller 50 will be described below in detail.

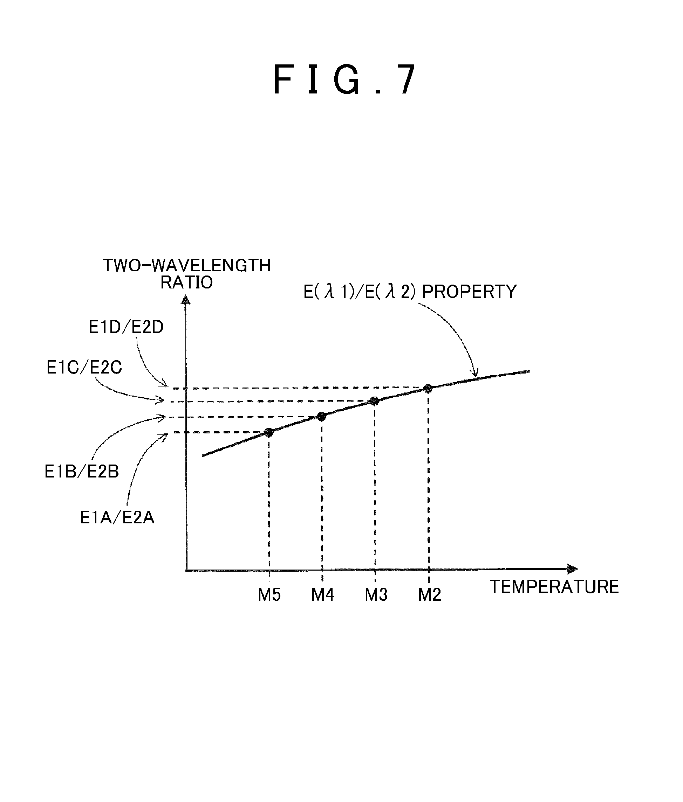

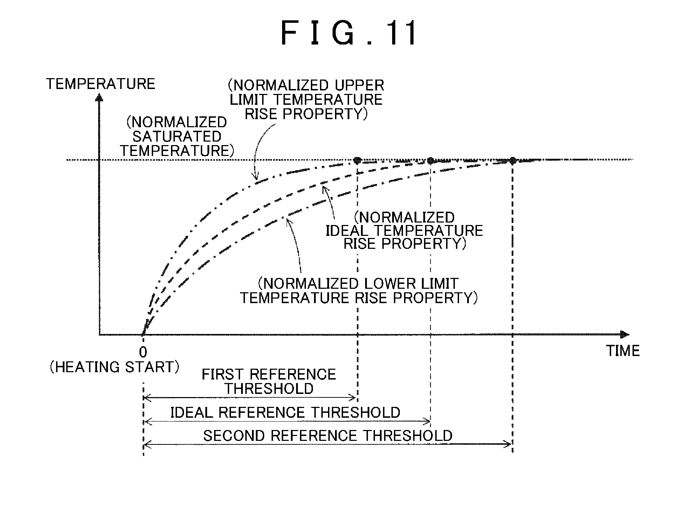

The storage 60 is a storage apparatus, for example, a hard disk. The storage 60 stores different temperature rise properties and the like in association with the pressure contact state of the measurement target to be determined. The storage 60 stores, for example, a normalized upper limit temperature rise property, a normalized ideal temperature rise property, a normalized lower limit temperature rise property, a normalized saturated temperature, a first reference threshold, an ideal reference threshold, and a second reference threshold depicted in FIG. 11. The storage 60 also stores an E(λ1)/E(λ2) property (see FIG. 7) that allows E(λ1)/E(λ2) that is the ratio between E(λ1) and E(λ2) representing the energy of the infrared rays (λ1) and (λ2) to be converted into temperature.

The controller 50 controls the optical non-destructive inspection apparatus 1 to measure the temperature rise property. When the duration until the arrival at the saturated temperature at which a gradient, in the measured temperature rise property, indicative of a change in temperature with respect to an elapsed time from a heating start point is equal to or smaller than a predetermined gradient does not fall between the first reference threshold and the second reference threshold (both the first reference threshold and the second reference threshold are stored in the storage 60), the controller 50 determines the measurement target to be a defective component in which the contact area of the pressure contact portion of the measurement target falls out of the range of areas of desired sizes or the range of desired pressures. A procedure for a method in which the controller 50 determines the pressure contact state at the pressure contact portions of the two workpieces will be described.

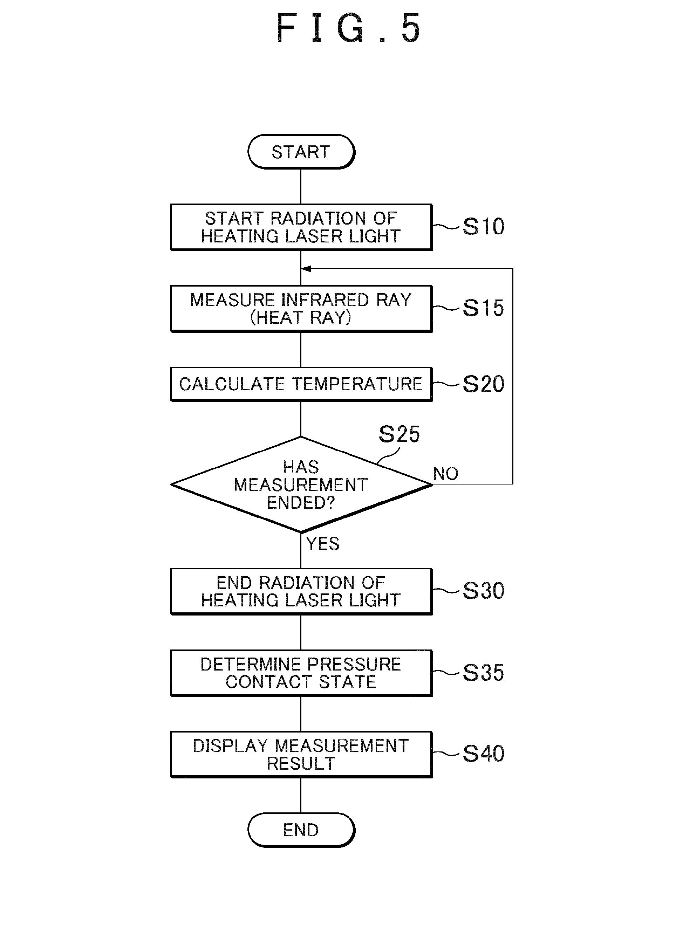

Now, a process procedure of the controller 50 in the optical non-destructive inspection apparatus 1 depicted in FIG. 4 will be described using a flowchart depicted in FIG. 5. The processes illustrated in FIG. 5 are executed by the controller 50 when the pressure contact state between the inner wall 91B and the elastic deformation portion 92B depicted in FIG 4 is inspected. The processes in the flowchart depicted in FIG. 5 will be sequentially described in detail.

In step S10, the controller 50 controls the heating laser light source to allow the heating laser light source to emit heating laser light, and proceeds to step S15. The heating laser light is guided to the measurement spot, and an infrared ray radiated from the measurement spot is guided to the first infrared detector and the second infrared detector. The output of the heating laser light is pre-adjusted to an amount of heat at which the workpieces are heated without being destroyed. Step S10 corresponds to heating in which the controller controls the heating laser light source to irradiate the measurement spot set on the measurement target with the heating laser light adjusted to the amount of heat at which the workpieces are heated without being destroyed, to heat the measurement spot.

In step S15, the controller 50 retrieves a detection value for the energy of the infrared ray (heat ray) with the first infrared wavelength (λ1) based on the detection signal from the first infrared detector, a detection value for the energy of the infrared ray (heat ray) with the second infrared wavelength (λ2) based on the detection signal from the second infrared detector, and the duration (heating time) from the start of radiation of the heating laser light in step S10, and proceeds to step S20. In step S20, the controller 50 determines the temperature at the measurement spot corresponding to the heating time based on the detection value from the first infrared detector and the detection value from the second infrared detector, and proceeds to step S25. In step S25, the controller 50 determines whether or not to end the measurement at the current timing. Upon determining that the determined temperature has reached the saturated temperature, the controller 50 determines that the measurement is to be ended at the current timing. For example, when the temperature determined in the current step S20 is higher than the temperature determined in the last step S20 by at most a predetermined value, the controller 50 determines that the saturated temperature has been reached. The saturated temperature is a temperature in a heat equilibrium state where the gradient of the temperature rise property illustrated in FIG. 8 is equal to or smaller than a predetermined value and where the temperature is substantially constant. The controller 50 proceeds to step S30 upon determining that the saturated temperature has been reached (the heat equilibrium state has been established) and that the measurement is to be ended at the current timing (Yes), and returns to step S 15 upon determining that the measurement is not to be ended at the current timing (No). In returning to step S15, the controller 50 more preferably waits a predetermined time (for example, approximately 1 ms) before the return because the temperature can be determined during the predetermined time interval. Steps S15 to S25 correspond to acquiring a temperature rise property, which includes detecting, via the controller 50, the infrared ray (heat ray) radiated from the measurement spot using the first and second infrared detectors to determine the temperature at the measurement spot to obtain the temperature rise property that is the temperature rise state of the measurement spot according to the heating time. A procedure for determining the temperature at the measurement spot in step S20 and a procedure for acquiring the temperature rise property will be described below. Upon proceeding to step S30, the controller 50 controls the heating laser light source to stop the radiation of the heating laser light, and proceeds to step S35.

In step S35, the controller 50 determines the duration from the heating start point until the arrival at the saturated temperature (the temperature at which the gradient indicative of a change in temperature with respect to an elapsed time is equal to or smaller than the predetermined gradient) which duration is included in the temperature rise property (FIG. 8) based on the temperatures determined in steps S15 to S25 and the heating time, to determine whether or not the pressure contact state at the pressure contact portions, and then proceeds to step S40. Step S35 corresponds to determining, via the controller, whether or not the contact areas and contact pressures of the pressure contact portions of the two workpieces are appropriate. A procedure for determining whether or not the pressure contact state is appropriate in step S35 will be described below.

In step S40, the controller 50 displays information on the result of the determination step (step S35) on the display to end the process. The display provides a view on a screen based on an output signal from the controller, and is, for example, a liquid crystal display. An example of the view on the screen will be described below.

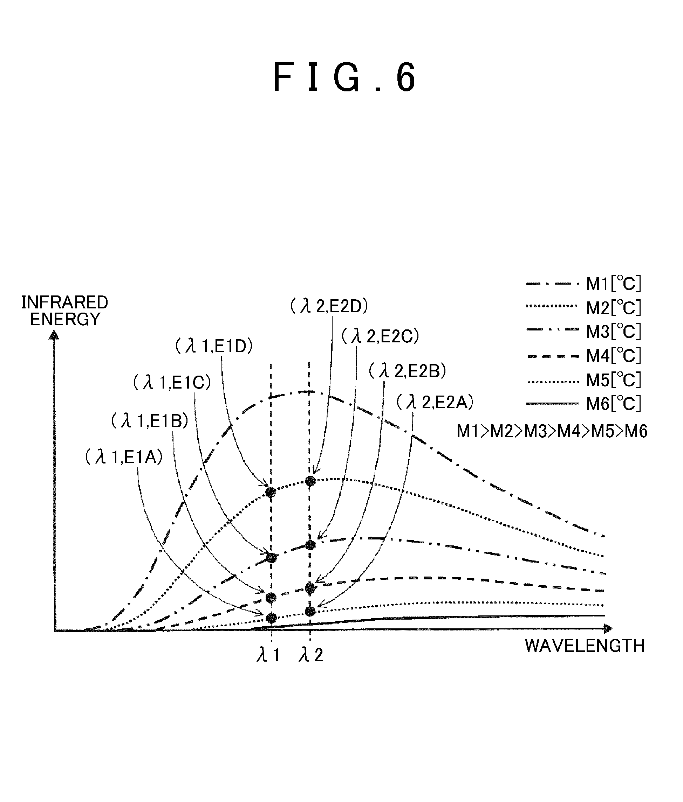

Now, the procedure for determining the temperature at the measurement spot in step S20 will be described in detail. For example, FIG. 6 illustrates an example of an infrared radiation property indicative of the relationship between the wavelength of an infrared ray radiated from a black body that completely absorbs and radiates radiated light (axis of abscissas) and the energy of the infrared ray at each wavelength (axis of ordinate), the relationship being observed when the black body is at temperatures M1 to M6. For example, it is assumed that the measurement spot is a black body and that the first infrared wavelength (λ1) is positioned at (λ1) depicted in FIG. 6 and that the second infrared wavelength (λ2) is positioned at (λ2) depicted in FIG. 6.

When the detection value of the infrared energy with the first infrared wavelength (λ1) detected by the first infrared detector and retrieved at the timing of a heating time T1 is denoted by E1A and the detection value of the infrared energy with the second infrared wavelength (λ2) detected by the second infrared detector and retrieved at the timing of the heating time T1 is denoted by E2A (see FIG. 6), the controller 50 determines the temperature at the measurement spot from the E1A/E2A, the ratio between the detection values, and the "E(λ1)/E(λ2)" property in a temperature and two-wavelength-ratio property (FIG. 7), and determines the temperature to be M5°C. The two-wavelength ratio is the ratio of the energy of infrared rays with two different wavelengths. The temperature and two-wavelength-ratio property illustrated in the example in FIG. 7 is prestored in the storage 60.

As described above, the controller 50 allows the correct temperature at the measurement spot to be determined using the ratio between the detection values without being affected by the reflectance (emissivity) of the measurement spot. As is understood, when the values retrieved at the timings of heating times T2, T3, and T4 are (E1B, E2B), (E1C, E2C), and (E1D, E2D), respectively, the temperatures at the timings of the heating times T2, T3, and T4 are M4, M3, and M2, respectively, based on the temperature and two-wavelength-ratio property. The controller 50 then determines the temperature rise property illustrated in the example in FIG 8 from the elapsed time from the start of radiation (corresponding to the heating time) and the temperature corresponding to the elapsed time.

As described above, the amount of heat transferred varies according to the size of the contact area and the magnitude of the contact pressure of the pressure contact portion. However, it is not very preferable to determine whether or not the pressure contact state is appropriate when the measurement targets have different saturated temperatures. Thus, as described below, the difference in saturated temperature is eliminated by normalizing the measured temperature so that the measurement targets have the same saturated temperature.

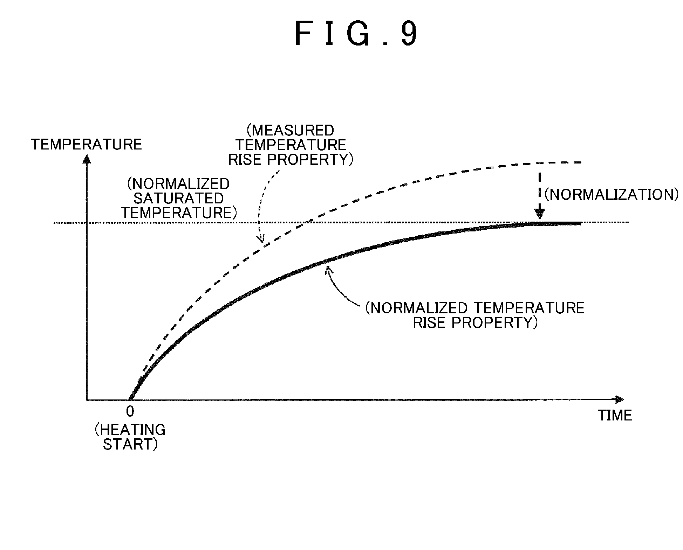

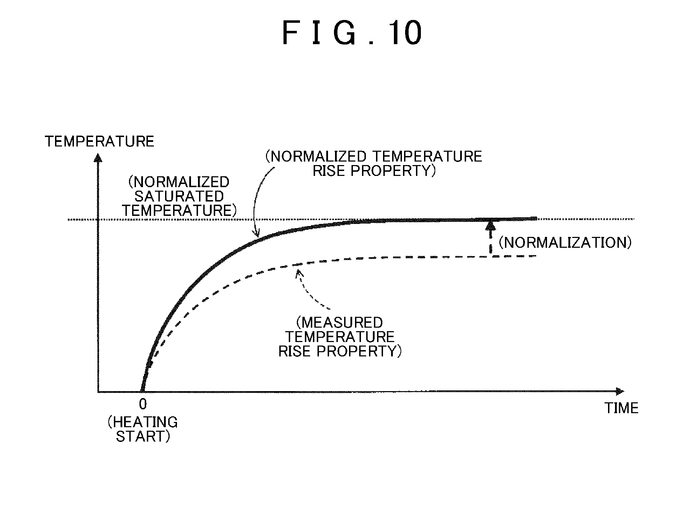

In step S35, the controller 50 executes processing involving compression or extension of the temperature rise property in a temperature (vertical axis) direction to determine a normalized temperature rise property so that the saturated temperature in the temperature rise property based on the temperatures determined in steps S 15 to S25 and the heating time (FIG. 8) is equal to a preset saturated temperature (no particular processing is executed in a time (horizontal axis) direction). For example, the normalized saturated temperature is set to a saturated temperature in the temperature rise property of a measurement target with a pressure contact portion, the contact area of which has an ideal size and the contact pressure of which has an ideal magnitude. The normalized saturated temperature is stored in the storage 60. Then, when the saturated temperature in the measured temperature rise property is higher than the normalized saturated temperature, the controller 50 can obtain the normalized saturated temperature by compressing the temperature rise property in the temperature (vertical axis) direction so that the saturated temperature in the measured temperature is equal to the normalized saturated temperature as depicted in FIG. 9. When the saturated temperature in the measured temperature rise property is lower than the normalized saturated temperature, the controller 50 can obtain the normalized saturated temperature by extending the temperature rise property in the temperature (vertical axis) direction so that the saturated temperature in the measured temperature is equal to the normalized saturated temperature as depicted in FIG. 10.

FIG. 11 illustrates an example where the normalized ideal temperature rise property (illustrated by a dashed line in FIG. 11), the normalized lower limit temperature rise property (illustrated by a long dashed short dashed line in FIG. 11), and the normalized upper limit temperature rise property (illustrated by a long dashed double-short dashed line in FIG. 11) are superimposed on one another. The normalized ideal temperature rise property results from normalization of the temperature rise property of a measurement target with a pressure contact portion, the contact area of which has an ideal size and the contact pressure of which has an ideal magnitude. The normalized lower limit temperature rise property results from normalization of the temperature rise property of a measurement target with a pressure contact portion, the contact area of which is at an allowable lower limit and the contact pressure of which is at an allowable lower limit. The normalized upper limit temperature rise property results from normalization of the temperature rise property of a measurement target with a pressure contact portion, the contact area of which is at an allowable upper limit and the contact pressure of which is at an allowable upper limit. When normalization is performed such that the saturated temperature is equal to the normalized saturated temperature, a variation in the size of the contact area of the pressure contact portion and a variation in the magnitude of the contact pressure of the pressure contact portion can be expressed in a graph for a period from the start (point) of heating until the arrival at the saturated temperature.

When the result of normalization of the temperature rise property of the measurement target does not fall between the normalized upper limit temperature rise property and normalized lower limit temperature rise property illustrated in FIG. 11, the contact area of the pressure contact portion of the measurement target falls out of the desired range or the contact pressure of the pressure contact portion of the measurement target falls out of the desired range. That is, when the result of normalization of the temperature rise property of the measurement target falls between the normalized upper limit temperature rise property and normalized lower limit temperature rise property illustrated in FIG. 11, the contact area of the pressure contact portion of the measurement target falls within the desired range and the contact pressure of the pressure contact portion of the measurement target falls within the desired range.

Whether the result of normalization of the determined temperature rise property falls between the normalized upper limit temperature rise property and normalized lower limit temperature rise property illustrated in FIG 11 may be determined by determining whether or not the duration from the heating start point until the arrival at the normalized saturated temperature falls between the first reference threshold (the duration from the heating start point until the arrival at the normalized saturated temperature in the normalized upper limit temperature rise property) and the second reference threshold (the duration from the heating start point until the arrival at the normalized saturated temperature in the normalized lower limit temperature rise property). In this case, in step S35, when the duration until the heat equilibrium state is established where a rise in temperature with respect to the elapsed time in the temperature rise property is equal to or smaller than a predetermined rise does not fall between the preset first reference threshold and the preset second reference threshold, the controller determines that the measurement target is a defective component with the contact area falling out of the range of areas of desired sizes or with the contact pressure falling out of the range of desired pressures (determines that the measurement target is acceptable when the duration falls between the first reference threshold and the second reference threshold). The normalized saturated temperature, the first reference threshold, and the second reference threshold are prestored in the storage.

In the above description, the first reference threshold is the duration from the start of heating until the arrival at the normalized saturated temperature in the normalized upper limit temperature rise property, and the second reference threshold is the duration from the start of heating until the arrival at the normalized saturated temperature in the normalized lower limit temperature rise property. However, the first reference threshold may be the duration from the start of heating until the arrival at 90% of the normalized saturated temperature in the normalized upper limit temperature rise property and the second reference threshold may be the duration from the start of heating until the arrival at 90% of the normalized saturated temperature in the normalized lower limit temperature rise property so that the measurement target can be determined to be acceptable when the duration until the arrival at 90% of the normalized saturated temperature in the result of normalization of the determined temperature rise property falls between the first reference threshold and the second reference threshold. A method for determining whether or not the pressure contact state is appropriate is not limited to the above-described method. For example, the measurement target may be determined to be acceptable when the saturated temperature in the determined temperature rise property falls within a predetermined temperature range, when the duration until the arrival at the saturated temperature in the non-normalized determined temperature rise property falls between the first reference threshold and the second reference threshold, or when an area enclosed by a graph for the normalized temperature rise property resulting from normalization of the determined temperature rise property falls within a predetermined range.

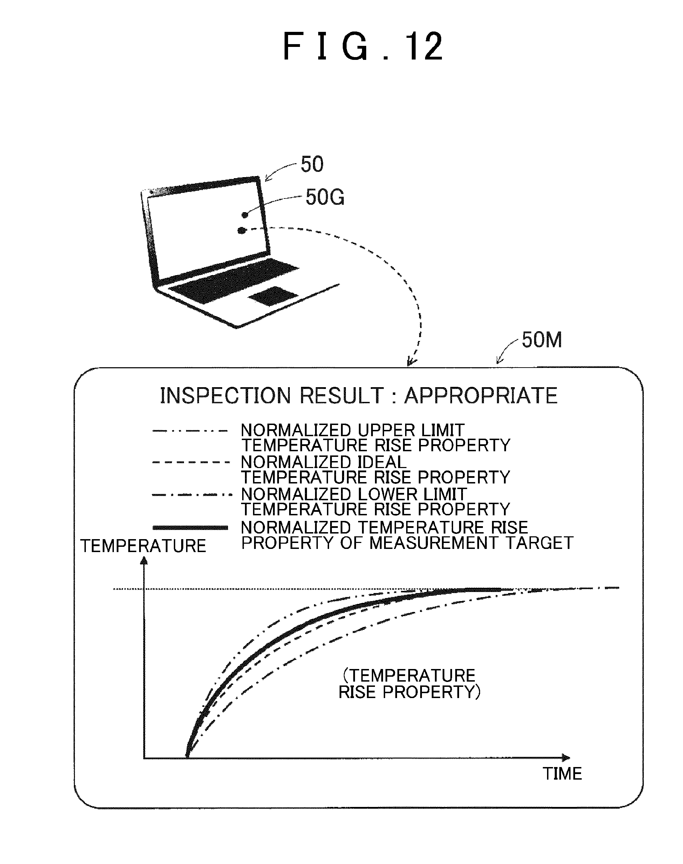

An example of the display in step S40 is illustrated in FIG. 12. In the example illustrated in FIG. 12, information on the result of the determination by the controller 50 is displayed on a screen 50M of a display 50G of the controller 50. In the example, the result of the determination is "appropriate", indicating the determination that the contact area and contact pressure of the pressure contact portion fall within the desired ranges. FIG. 12 also illustrates an example where the normalized temperature rise property of the measurement target (illustrated by a solid line in the screen 50M), the normalized lower limit temperature rise property of the measurement target (illustrated by a long dashed short dashed line in the screen 50M), the normalized upper limit temperature rise property of the measurement target (illustrated by a long dashed double-short dashed line in the screen 50M), and the normalization ideal temperature rise property of the measurement target (illustrated by a dashed line in the screen 50M) are superimposed on one another in a part of the screen 50M. Simply by viewing the temperature rise property graph, an operator can easily determine that the pressure contact state of the measurement target falls within the allowable range but that the graph deviates slightly upward. Thus, the temperature rise property graph is very convenient for quality management or the like.

In the above description, whether or not the pressure contact state at the pressure contact portions where the elastic deformation portion 92B of the press fit pin 92 has been inserted through the inner wall 91B of the through-hole 91 is determined. The pressure contact portions are coupled together by pressure contact without being soldered, but when the result of the determination indicates that the pressure contact state is acceptable, a desired conductivity can be more reliably ensured by soldering the pressure contact portions together as follows. A soldering step described below may be executed between step S35 and step S40 depicted in FIG. 5 or omitted.

First, a prerequisite is set as follows. At least one of the pressure contact portions of the two workpieces is plated with an alloy or a metal having a lower melting point than the conductive member of the pressure contact portions of the two workpieces (for example, solder plating or tin plating). For example, the inner wall 91B of the through-hole 91 is plated with solder. In the heating, the controller controls the heating laser light source to irradiate the measurement spot with heating laser light with an output adjusted to an amount of heat at which the workpieces are heated without being destroyed and which corresponds to a melting point lower than the melting point of the plating.

Then, upon determining that the measurement target is acceptable, the controller increases the output of the heating laser light source to an output adjusted to an amount of heat at which the workpieces are heated without being destroyed and which corresponds to a melting point equal to or higher than the melting point of the plating, and then radiates heating laser light to the measurement spot for a predetermined time to melt the plating, soldering the workpieces together at the pressure contact portions thereof. The step of soldering corresponds to soldering. As described above, after the two workpieces coupled together by pressure contact without being soldered are determined to be in the desired pressure contact state, the pressure contact portions can be appropriately and easily soldered together, allowing the desired conductivity to be reliably ensured. Furthermore, for example, plating shaved portions and fine slivers of tin or the like may be melted to establish a more reliable pressure contact state (electrically continuous state). No step of removing plating shaved pieces is needed. In the above description, the soldering is executed after the heating. However, the heating and the soldering may be executed at the same time. In this case, in the heating, the controller may control the heating laser light source to irradiate the measurement spot with heating laser light with an output adjusted to an amount of heat at which the workpieces are heated without being destroyed and which corresponds to a melting point equal to or higher than the melting point of the plating. This allows the inspection to be finished in a shorter time than a case where the heating and the soldering are separately executed.

In the optical non-destructive inspection apparatus described above in the present embodiment, the state of the measurement target is determined using the temperature rise property during a period of approximately several tens of milliseconds from the start of heating with heating laser light until the arrival at the saturated temperature, and thus needs a very short inspection time. Furthermore, since the pressure contact state of the pressure contact portion can be inspected in a noncontact manner, a vibrator of an ultrasonic oscillator, a sensor, and like need not be fixed to the pressure contact portion or to the vicinity of the pressure contact portion. Inspection can be thus easily and quickly performed without much effort. In addition, the heat transfer state is determined to determine the pressure contact state between the conductive member (the inner wall of the through-hole) and the conductive member (the elastic deformation portion of the press fit pin), enabling the electrically continuous state that is to be appropriately determined. Therefore, compared to a method of checking the insertion position in an image, the present embodiment enables appropriate inspection of the electrically continuous state to be originally inspected, allowing the inspection to be more reliably performed. In addition, even when the saturated temperature varies according to the temperature rise property, the temperature rise property is normalized so as to allow the use of a common normalized saturated temperature, in spite of different saturated temperatures by compressing or extending the temperature rise property in the temperature (vertical axis) direction so as to achieve a preset normalized saturated temperature to obtain a normalized temperature rise property. This allows more accurate determination to be achieved.

When the heating laser light source 21, the light concentrating collimator 10, the heating laser light guide, the at least one infrared detector (heat ray detector), the infrared light guide (heat ray light guide), and the controller 50 are provided in order to carry out the above-described process procedure, an optical non-destructive inspection apparatus can of course be configured, in which the controller determines whether or not the contact area of each of the pressure contact portions of the two members that are measurement targets falls within the allowable range and whether or not the contact pressure of each pressure contact portion falls within the allowable range.

Various changes, additions, and deletions may be made to the process procedure, configuration, structure, appearance, shape, and the like of the optical non-destructive inspection method and the optical non-destructive inspection apparatus in the present invention without departing from the spirits of the present invention. For example, an optical non-destructive inspection apparatus or the like can be configured which includes a single infrared detector and in which a reflectance measuring laser light source radiates reflectance measuring laser light to the measurement spot so that the reflectance measuring laser light reflected from the measurement spot is detected by an optical sensor or the like and so that a detection value detected by the infrared detector is corrected based on a calculated reflectance. That is, the optical non-destructive inspection apparatus may include at least one infrared detector (heat ray detector).

The example of the infrared radiation property (FIG. 6) described in the present embodiment and the positions of the first infrared wavelength (λ1) and second infrared wavelength (λ2) illustrated in the infrared radiation property are only examples. The present invention is not limited to the infrared radiation property and the positions of the infrared wavelengths. Furthermore, the expressions "equal to or larger than" (≥), "equal to or smaller than" (≤), "larger than" (>), "smaller than" (<), the expression of B between A and C (A < B < C) may or may not include an equal sign. In addition, the numerical values used in the description of the present embodiment are only examples, and the present invention is not limited to the numerical values.

In the present embodiment, the pressure contact portions where the elastic deformation portion of the press fit pin is in pressure contact with the inner wall of the through-hole have been described by way of example. However, the two workpieces are not limited to the press fit pin and the through-hole. The present embodiment is applicable to determination of whether or not the pressure contact portions of various two workpieces formed of conductive members are appropriate. Furthermore, the type of the plating is not limited to solder plating and tin plating but various types of plating may be used.

## Claims

1. An optical non-destructive inspection method, in which
a pressure contact state is determined at pressure contact portions of two workpieces coupled together by pressure contact without being soldered, and the pressure contact portion of a first workpiece and the pressure contact portion of a second workpiece being formed of conductive members,
the optical non-destructive inspection method comprising:
heating a measurement spot using a heating laser light source that sets the measurement spot on a surface of the first workpiece near the pressure contact portion, the surface being a surface of the conductive member including the pressure contact portion, the heating laser light source emitting heating laser light with a predetermined laser wavelength, at least one heat ray detector that enables a heat ray to be detected, and a controller that controls the heating laser light source and that retrieves a detection signal from the heat ray detector, the heating including controlling the heating laser light source via the controller to irradiate the measurement spot with the heating laser light adjusted to have an amount of heat at which the workpieces are heated without being destroyed;
acquiring a temperature rise property that is a temperature rise state of the measurement spot according to a heating time by, while performing the heating through the heating step, detecting, via the controller, a heat ray radiated from the measurement spot using the heat ray detector to determine a temperature at the measurement spot; and
determining, via the controller, whether or not the pressure contact state at the pressure contact portions of the two workpieces, which includes a contact area and a contact pressure of each pressure contact portion is appropriate based on the temperature rise property of the measurement spot that is a heating point affected by an amount of heat transferred.

2. The optical non-destructive inspection method according to claim 1, wherein
at least one of the pressure contact portions of the two workpieces is plated with an alloy or a metal having a lower melting point than each of the conductive members of the pressure contact portions of the two workpieces, and
in the heating, the controller controls the heating laser light source to irradiate the measurement spot with the heating laser light with an output adjusted to an amount of heat at which the workpieces are heated without being destroyed and which corresponds to a melting point lower than the melting point of the plating, and
the method further comprises soldering the two workpieces at the pressure contact portions when the workpieces are determined to be acceptable in the determination, the soldering including increasing, via the controller, the output of the heating laser light source to an output adjusted to an amount of heat at which the workpieces are heated without being destroyed and which corresponds to a melting point equal to or higher than the melting point of the plating, and then irradiating the measurement spot with the heating laser light at the adjusted output for a predetermined time to melt the plating.

3. The optical non-destructive inspection method according to claim 1, wherein
at least one of the pressure contact portions of the two workpieces is plated with an alloy or a metal having a lower melting point than each of the conductive members of the pressure contact portions of the two workpieces, and
in the heating, the controller controls the heating laser light source to irradiate the measurement spot with the heating laser light with an output adjusted to an amount of heat at which the workpieces are heated without being destroyed and which corresponds to a melting point equal to or higher than a melting point of the plating.

4. The optical non-destructive inspection method according to any one of claims 1 to 3, wherein
in the determination, when a duration from a start point of radiation of the heating laser light to the measurement spot until a heat equilibrium state is established where a temperature rise with respect to an elapsed time in the temperature rise property is equal to or lower than a predetermined rise does not fall between a preset first reference threshold and a preset second reference threshold, the controller determines the workpiece to be a defective workpiece with the contact area falling out of a range of areas of desired sizes or with the contact pressure falling out of a range of desired pressures.

5. An optical non-destructive inspection apparatus that executes the optical non-destructive inspection method according to any one of claims 1 to 4, the apparatus comprising:
the heating laser light source;
a light concentrating collimator that concentrates parallel light entering the light concentrating collimator through a first side thereof along an optical axis, at the measurement spot set as a focal position so that the light exits the light concentrating collimator through a second side thereof, the light concentrating collimator converting the light entering the light concentrating collimator through the second side thereof after radiation and reflection from the measurement spot, into measurement light that is parallel light along the optical axis so that the measurement light exits the light concentrating collimator through the first side thereof;
a heating laser light guide that converts the heating laser light into parallel light and guides the parallel light to the first side of the light concentrating collimator;
the at least one heat ray detector;
a heat ray light guide that guides a heat ray contained in the measurement light and corresponding to heat radiated from the measurement spot to the heat ray detector; and
the controller.
